Europäisches Patentamt

European Patent Office

Office européen des brevets

(19)

(11) EP 1 599 076 A1

(12) EUROPEAN PATENT APPLICATION

(43) Date of publication:
23.11.2005 Bulletin 2005/47

(51) Int Cl.⁷: $H05K\ 1/05$, $H05K\ 1/02$, $H05K\ 3/30$, $H01L\ 23/498$

(21) Application number: 05010862.0

(22) Date of filing: 19.05.2005

(84) Designated Contracting States:
AT BE BG CH CY CZ DE DK EE ES FI FR GB GR HU IE IS IT LI LT LU MC NL PL PT RO SE SI SK TR
Designated Extension States:
AL BA HR LV MK YU

(30) Priority: 20.05.2004 JP 2004150928

(71) Applicant: NITTO DENKO CORPORATION
Ibaraki-shi, Osaka 567-8680 (JP)

(72) Inventors:
• Kakamura, Kei
Ibaraki-shi Osaka 567-8680 (JP)

• Ishizaka, Hitoshi
Ibaraki-shi Osaka 567-8680 (JP)
• Yoshida, Atsushi
Ibaraki-shi Osaka 567-8680 (JP)
• Hikita, Takami
Ibaraki-shi Osaka 567-8680 (JP)

(74) Representative: Schwabe - Sandmair - Marx
Stuntzstrasse 16
81677 München (DE)

(54) Wired circuit board

(57)     A wired circuit board on which a highly reliable conductor pattern is formed, to allow an electronic component to be mounted on it with improved accuracy. An insulating layer 3 is formed on a metal supporting layer 2 having a degree of surface brilliancy of 150-500% in such a manner as to have a haze value of 20-50% and also a conductor pattern 4 is formed on the insulating layer 3, thereby producing a TAB tape carrier 1. In this TAB tape carrier 1, since the metal supporting layer 2 has a specified degree of surface brilliancy of 500% or less, the pattern design of the conductor pattern 4 is optically examined to determine whether it is good or bad with high accuracy. Also, since the metal supporting layer 2 has a specified degree of surface brilliancy of 150% or more and the insulating layer 3 has a specified haze value ranging from 20% to 50%, the light for the alignment of an electronic component 21 can be allowed to smoothly pass through the insulating layer 3, and as such can allow the electronic component 21 to be mounted with high accuracy.

FIG. 6

EP 1 599 076 A1

## FIG. 7

## Description

## BACKGROUND OF THE INVENTION

### Field of the Invention

The present invention relates to a wired circuit board and, more particularly, to a wired circuit board applied to a TAB tape carrier and the like.

### Description of the Prior Art

A wired circuit board, such as a TAB tape carrier, includes a metal supporting layer of e.g. a copper foil serving as a stiffening layer. In the production of this wired circuit board, an insulating layer is formed on the metal supporting layer, first; then a conductor pattern is formed on the insulating layer; and then the whole area of the metal supporting layer, except an area to be stiffened, is removed by etching (Cf. FIG. 2 of JP Laid-open (Unexamined) Patent Publication No. 2000-340617, for example).

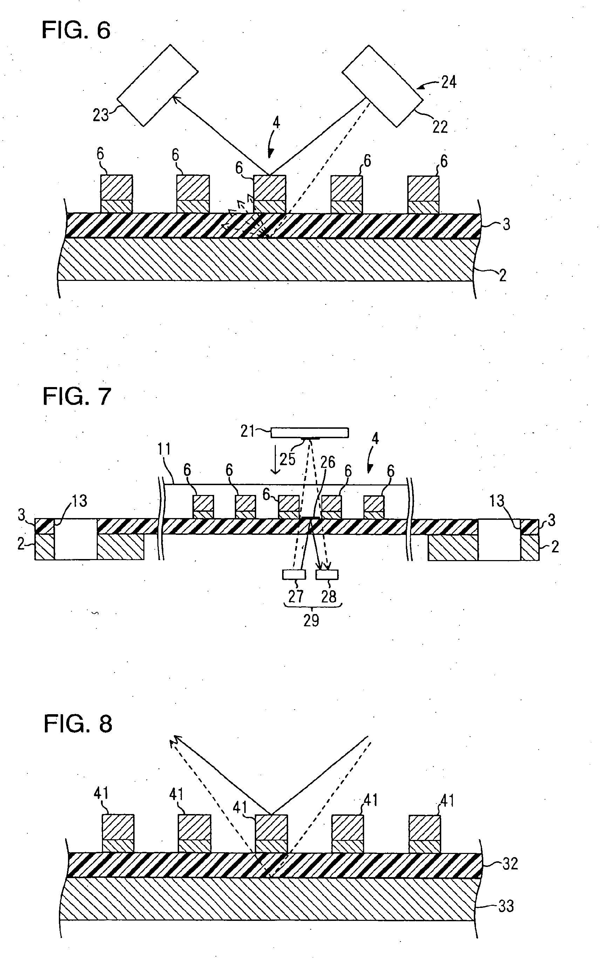

In the production process mentioned above, it is usual that the pattern design of the conductor pattern is optically examined before the removal of the metal supporting layer. To be more specific, the pattern design of the conductor pattern is examined for example by irradiating an area of the insulating layer 32 including the conductor pattern 41 with light (a solid-line arrow in FIG. 8) and detecting the reflected light from the conductor pattern 41, as shown in FIG. 8.

Meanwhile, along with the advance of fine pitch of the conductor pattern, improvement in examination accuracy for determination on whether the pattern design of the conductor pattern produced is a conforming pattern design or not is increasingly demanded. There may be cases in this examination, however, that the reflected light from the metal supporting layer 33 (a chain-line arrow in FIG. 8) may cause erroneous determination of the examination. Accordingly, prevention of this erroneous determination of the examination is required for improvement of the examination accuracy.

In addition, along with miniaturization of electronic components in recent years, accurate alignment is increasingly required for mounting electronic components on the wired circuit board.

## SUMMARY OF THE INVENTION

It is an object of the invention to provide a wired circuit board on which a highly reliable conductor pattern is formed, to allow an electronic component to be mounted on it with improved accuracy.

The present invention provides a wired circuit board comprising a metal supporting layer having a degree of surface brilliancy of 150-500%, an insulating layer formed on the metal supporting layer, and a conductor pattern formed on the insulating layer.

Also, the present invention provides a wired circuit board comprising an insulating layer having a haze value of 20-50%, and a conductor pattern formed on the insulating layer.

In the wired circuit board of the present invention, since the metal supporting layer has a specified degree of surface brilliancy of 500% or less, the metal supporting layer can diffuse the light reflected from the metal supporting layer when the pattern design of the conductor pattern is optically examined to determine whether is good or bad: This can allow the possibility of the erroneous determination of the examination to decrease, and as such can allow improvement of the examination accuracy. This can produce the result that the wired circuit board on which highly reliable conductor patterns are formed can be provided.

Also, in the wired circuit board of the present invention, since the metal supporting layer has a specified degree of surface brilliancy of 150% or more, excessive increase of a haze value of the insulating layer exposed from an opening of the metal supporting layer can be prevented. This can allow the light for the alignment of an electronic component to smoothly pass through the insulating layer, and as such can allow the electronic component to be mounted with high accuracy.

Further, in the wired circuit board of the present invention, the insulating layer has a specified haze value of 20-50%. This can allow the light for the alignment of the electronic component to smoothly pass through that insulating layer, and as such can allow the electronic component to be mounted with high accuracy.

## DESCRIPTION OF THE DRAWINGS

In the drawings:

FIG. 1 is a partial plan view showing a TAB tape carrier taken as an embodiment of a wired circuit board of the present invention;
FIG. 2 is a partially enlarged plan view of the TAB tape carrier shown in FIG. 1;
FIG. 3 is a partial rear view of the TAB tape carrier shown in FIG. 1;
FIG. 4 is a production process drawing showing production processes for producing the TAB tape carrier shown in FIG. 1 in section taken along line A-A' of FIG. 2: (a) showing the process of preparing a metal supporting layer; (b) showing the process of forming an insulating layer on the metal supporting layer; (c) showing the process of forming a seed film on the whole area of the insulating layer; and (d) showing the process of forming sprocket holes;

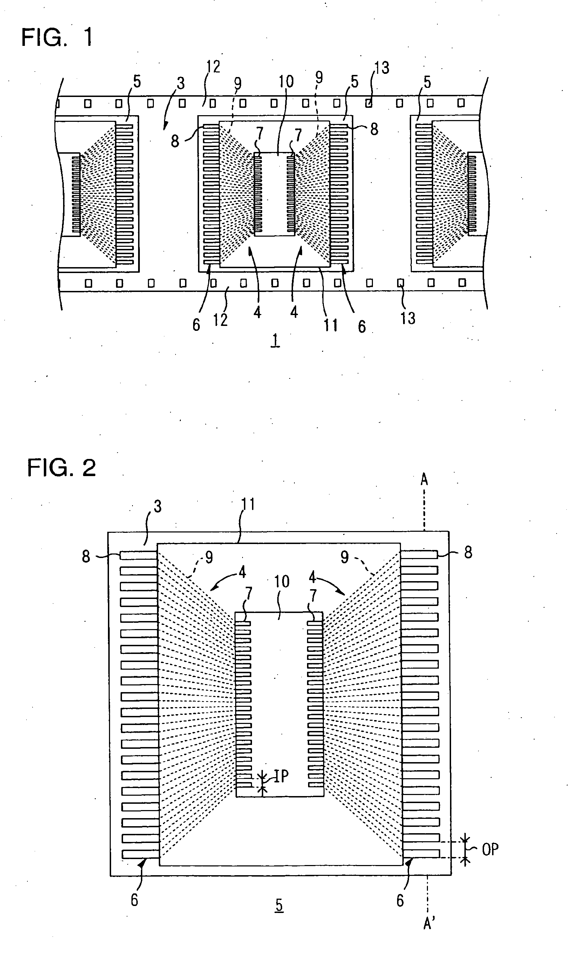

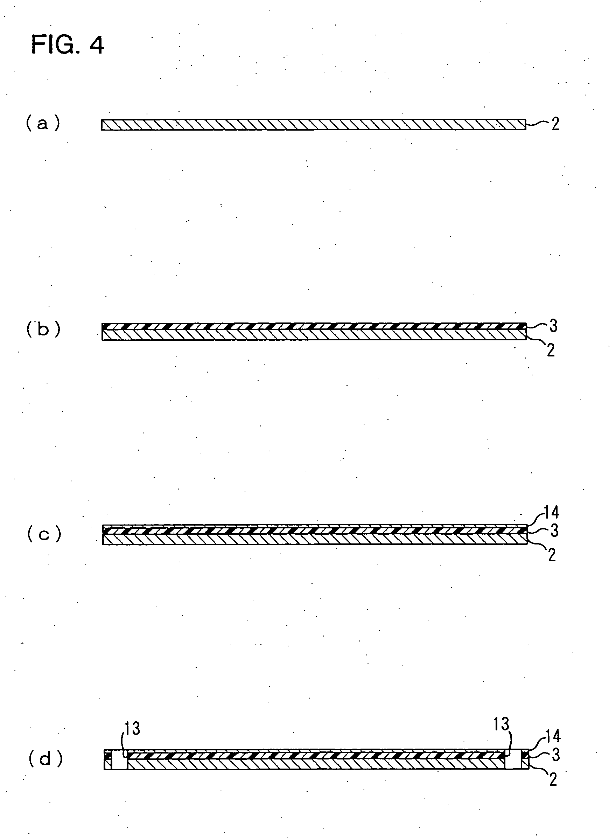

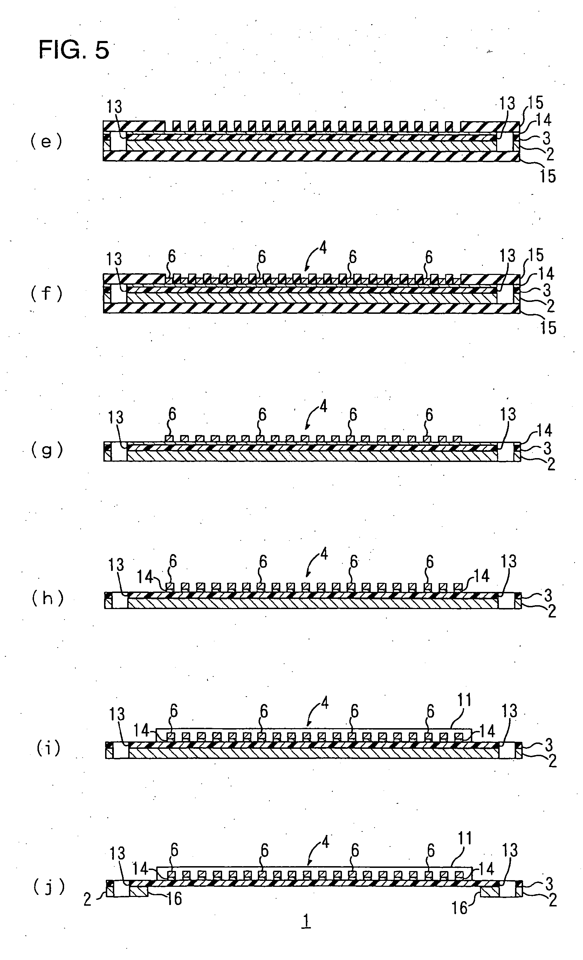

FIG. 5 is a process drawing, which is the sequence of FIG. 4, showing production processes for producing the TAB tape carrier shown in FIG. 1 in section taken along line A-A' of FIG. 2: (e) showing the process of forming a plating resist on the seed film; (f) showing the process of forming a conductor pattern on the seed film exposed from the plating resist by electrolytic plating; (g) showing the process of removing the plating resist; (h) showing the process of removing the seed film exposed from the conductor pattern; (i) showing the process of forming a covering layer; and (j) showing the process of forming an opening in the metal supporting layer at a location corresponding to the conductor pattern forming portion;

FIG. 6 is an explanatory drawing for explaining the process of optically examining a pattern design of the conductor pattern in the production of the TAB tape carrier shown in FIG. 1;

FIG. 7 is an explanatory drawing for explaining the positioning process for mounting electronic components on the TAB tape carrier shown in FIG. 1; and

FIG. 8 is an explanatory drawing for explaining the process of optically examining a pattern design of the conductor pattern in the production of the conventional TAB tape carrier.

## DETAILED DESCRIPTION OF THE PREFERRED EMBODIMENTS

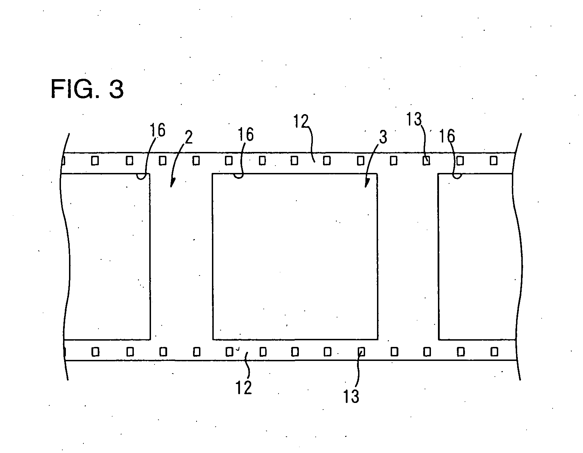

FIG. 1 is a partial plan view showing a TAB tape carrier taken as an embodiment of a wired circuit board of the present invention; FIG. 2 is a partially enlarged plan view of the TAB tape carrier shown in FIG. 1; FIG. 3 is a partial rear view of the TAB tape carrier shown in FIG. 1; and FIGS. 4 and 5 are production process drawings showing production processes for producing the TAB tape carrier shown in FIG. 1

The TAB tape carrier 1 comprises, for example, a metal supporting layer 2 in the form of a tape extending continuously in the longitudinal direction, an insulating layer 3 formed on the metal supporting layer 2, and conductor patterns 4 formed on the insulating layer 3, as shown in FIG. 5 (j).

This TAB tape carrier is provided with a plurality of conductor pattern forming portions 5 spaced from each other at predetermined intervals on the insulating layer 3 along a longitudinal direction of the metal supporting layer 2 (or along a longitudinal direction of the TAB tape carrier 1, which is hereinafter sometimes simply referred to as "the longitudinal direction").

As shown in FIG. 2, each conductor pattern forming portion 5 of a generally rectangular form, when viewed from top, has, in a center portion thereof, a mounting portion 10 of a generally rectangular form, when viewed from top, for mounting an electronic component 21 (Cf. FIG. 7).

The conductor patterns 4 are formed at both lengthwise sides of the mounting portion 10 in the each conductor pattern forming portion 5. Specifically, each conductor pattern 4 comprises a number of lines of wire 6 arranged at predetermined spaced locations, and each line of wire 6 comprises an inner lead 7, an outer lead 8, and a junction lead 9 which are integrally formed to extend continuously.

The inner leads 7 are arranged to face into the mounting portion 10 and extend along the longitudinal direction and are arranged at predetermined spaced locations to be in parallel with each other in a widthwise direction of the TAB tape carrier 1. An inner lead pitch IP (i.e., a total length of a width of an inner lead 7 and a space (distance) between two adjoining inner leads 7) is set to be 60 μm or less, or preferably 50 μm or less. It is usually set to be 10 μm or more. The inner lead pitch IP thus set to be 60 μm or less can allow realization of high density wiring.

The width of the single inner lead 7 is set to be in the range of 5-50 μm, or preferably 10-40 μm, and the space (distance) between two adjoining inner leads 7 is set to be in the range of 5-50 μm, or preferably 10-40 μm.

The outer leads 8 are arranged to extend along the longitudinal direction at both lengthwise ends of each conductor pattern forming portion 5 and are arranged at predetermined spaced locations to be in parallel with each other in the widthwise direction. An outer lead pitch OP (i.e., a total length of a width of an outer lead 8 and a space (distance) between two adjoining outer leads 8) is set to be, for example, in the order of 100-1,000% of the inner lead pitch IP of the inner lead 7. This means that the outer lead pitch OP is set to be wider than the inner lead pitch IP.

The junction leads 9 interconnect the respective inner leads 7 and the respective outer leads 8 to provide electrical continuity therebetween and are arranged to radiate out from the inner leads 7 of narrowed pitch toward the outer leads 8 of widened pitch in the longitudinal direction.

In a region of the conductor pattern 4 where the respective junction leads 9 are arranged, a covering layer 11, such as a solder resist, is provided on the insulating layer 3, to cover the respective junction leads 9. Specifically, the covering layer 11 is formed in a generally rectangular frame form to surround the mounting portion 10 of the each conductor pattern forming portion 5 so that all junction leads 9 can be covered with the covering layer 11.

The inner leads 7 and the outer leads 8 are preferably covered with a nickel plating layer or a gold plating layer in a proper manner, though not shown.

In this TAB tape carrier 1, rectangular openings 16, when viewed from bottom, are formed in the metal supporting layer 2 to correspond to the rear sides of the respective conductor pattern forming portions 5, as shown in FIG. 3.

Carrying portions 12 to carry the TAB tape carrier 1 are formed in this TAB tape carrier 1. The carrying portions 12 are provided at both widthwise side ends of the TAB tape carrier 1, extending along the longitudinal direction, as shown in FIG. 1. A plurality of sprocket holes 13 are formed in each of the carrying portions 12. The sprocket holes 13 on one widthwise side and the sprocket holes 13 on the other widthwise side are arranged to correspond in position to each other in the widthwise direction, so that the sprocket holes 13 are engaged with sprocket wheels and the like, to carry the TAB tape carrier 1. The sprocket holes 13 are formed at regularly spaced locations in the longitudinal direction of the TAB tape carrier 1, to extend through the TAB tape carrier 1 (extend through the metal supporting layer 2 and the insulating layer 3). The sprocket holes 13 are formed in square hole form of 1.981 × 1.981mm, and the space between the sprocket holes 13 is set to be 4.75mm, for example.

Next, the production method of this TAB tape carrier 1 will be explained below.

In this method, a metal supporting layer 2 is prepared, first, as shown in FIG. 4(a). A stainless foil, a copper foil, a copper alloy foil and the like is used for the metal supporting layer 2. The metal supporting layer 2 has a thickness of e.g. 3-100μm, preferably 5-30μm, or further preferably 8-20 μm, and has a width of e.g. 100-1,000mm, or preferably 150-400mm.

The metal supporting layer 2 prepared has a degree of surface brilliancy of 150-500%, or preferably 150-300%. When the metal supporting layer 2 has the degree of surface brilliancy of less than 150%, the positioning for mounting the electronic components 21 on the conductor patterns 4 becomes difficult, as mentioned later. On the other hand, when the metal supporting layer 2 has the degree of surface brilliancy of more than 500%, erroneous determination of the examination is easily caused in the examination process of the conductor pattern 4, as mentioned later.

The degree of surface brilliancy can be determined in conformity with JIS (Japanese Industrial Standards) Z 8741 and can be measured by a usual glossmeter.

The degree of surface brilliancy of the metal supporting layer 2 can be adjusted to the above-mentioned range, for example, in the metal rolling process in the production of the metal supporting layer 2. When the metal supporting layer 2 has a high degree of surface brilliancy, the degree of surface brilliancy can be adjusted to the above-mentioned range by the surface roughening process using chemical and the like.

Although a line of TAB tape carrier 1 is illustrated in FIGS. 4 and 5, it is usual that a plurality of TAB tape carriers 1 arranged in rows in the widthwise direction of the metal supporting layer 2 are produced simultaneously and then are split into individual ones.

For instance, when a stainless foil having a width of 250mm is used, four rows of TAB tape carriers 1 having a width of 48mm are produced simultaneously, while on the other hand, when a stainless foil having a width of 300mm is used, four rows of TAB tape carriers 1 having a width of 70mm are produced simultaneously.

Sequentially, an insulating layer 3 is formed on the metal supporting layer 2, as shown in FIG. 4(b). The insulating materials that may be used for forming the insulating layer 3 include, for example, synthetic resins, such as, for example, polyimide resin, acrylic resin, polyether nitrile resin, polyether sulfonic resin, polyethylene terephthalate resin, polyethylene naphthalate resin and polyvinyl chloride resin. Polyimide resin is preferably used.

The insulating layer 3 is formed on the metal supporting layer 2, for example, by the process that resin solution is coated over the metal supporting layer 2 and, after dried, is cured by heating. The resin solution can be prepared by dissolving the resin cited above in an organic solvent and the like. For example, solution of polyamic acid resin which is a precursor of polyimide resin can be used as the resin solution. The resin solution can be coated over the metal supporting layer 2 by a known coating method, such as a doctor blade method and a spin coat method. Then, after the resin solution is dried by heating properly, it is cured by heating at 200-600°C, whereby the insulating layer 3 of a flexible resin film is formed on the metal supporting layer 2.

The insulating layer 3 can also be formed by the process that a resin film previously formed in film form is adhesively bonded to the metal supporting layer 2 via adhesive.

Further, the insulating layer 3 can be formed in the form of a predetermined pattern, for example, by the process that after solution of photosensitive resin, such as photosensitive polyamic acid resin, is coated over the metal supporting layer 2 and then is exposed to light and developed.

The insulating layer 2 thus formed has a thickness of e.g. 50 μm or less, preferably 30 μm or less, or further preferably 15 μm or less. It usually has a thickness of 3 μm or more.

Sequentially, a conductor pattern 4 is formed in the form of the above-said wired circuit pattern on the surface of the insulating layer 3. The conductive materials used for forming the conductor pattern 4 include, for example, copper, nickel, gold, solder or alloys thereof. Copper is preferably used. The conductor pattern 4 can be formed by a known patterning process, such as, for example, a subtractive process and an additive process. Of these patterning processes, the additive process is preferably used from the viewpoint that it can facilitate the fine pitch of the conductor pattern 4, as shown in FIGS. 4(c)-5(h).

In the additive process, a thin conductor film serving as a seed film 14 is formed on the entire surface of the insulating layer 3, first, as shown in FIG. 4(c). Vacuum deposition or sputtering, in particular, is preferably used for forming the seed film 14. Also, chromium and copper are preferably used as the conductor serving as the seed film 14. To be more specific, it is preferable that for example a thin chromium film and a thin copper film are formed on the entire surface of the insulating layer 3 sequentially by the sputtering. Also, it is preferable that when forming the seed film 14, the thin chromium film and the thin copper film are set to have thicknesses of 100-600Å and 500-2,000Å, respectively

Then, a plurality of sprocket holes 13 are formed at both widthwise end portions of the TAB tape carrier 1 along the longitudinal direction, to extend through the metal supporting layer 2, the insulating layer 3, and the seed film 14 in the thickness direction thereof, as shown in FIG. 4(d). These sprocket holes 13 can be formed by a known process, such as, for example, drilling, laser process, punching, and etching. The punching is preferably used for forming the sprocket holes 13.

Then, a plating resist 15 having a reversal pattern reverse to the above-said pattern of the wired circuit pattern is formed on the seed film 14, as shown in FIG. 5(e). The plating resist 15 is formed in a predetermined resist pattern by a known process using dry film photoresist, for example. Also, the plating resist 15 is formed on the entire surface of the metal supporting layer 2 as well.

Sequentially, the conductor pattern 4 having the above-said wired circuit pattern is formed on the seed film exposed from the plating resist 15 by electrolytic plating, as shown in FIG. 5(f). The electrolytic copper plating is preferably used.

Then, the plating resist 15 is removed by a known etching process, such as a chemical etching (wet etching) or by peeling, as shown in FIG. 5(g). Thereafter, the seed film 14 exposed from the conductor pattern 4 is also removed by a known etching process such as the chemical etching, as shown in FIG. 5(h).

As a result of this, the conductor pattern 4 is formed in the form of wired circuit pattern comprising a number of lines of wire 6 each comprising the inner lead 7, the outer lead 8, and the junction lead 9 which are integrally formed to extend continuously, as mentioned above. The conductor patterns 4 thus formed have a thickness of e.g. 3-50 µm, or preferably 5-25 µm.

Then, the pattern design of the conductor pattern 4 is optically examined in this stage. In this examining process, a position detecting apparatus 24 comprising a light source 22 and a photo detector 23 is set so that the light source 22 and the photo detector 23 are arranged in opposition with each other over the insulating layer 3 including the conductor pattern 4, as shown in FIG. 6. When light is emitted from the light source 22 toward the insulating layer 3 including the conductor pattern 4, the light is reflected by the conductor pattern 4 and the reflected light is detected by the photo detector 23. The pattern design of the conductor pattern 4 is optically examined to determine whether it is good or bad, using this position detecting apparatus 24 in this manner.

In this examination, even when the light emitted from the light source 22 passes through the insulating layer 3 and is reflected by the metal supporting layer 2, since the metal supporting layer 2 has a specified degree of surface brilliancy of 500% or less, the metal supporting layer 2 can diffuse the light reflected from the metal supporting layer 2. This can allow the possibility of the erroneous determination of the examination to decrease, and as such can allow improvement of the examination accuracy.

Sequentially, the covering layer 11 is formed in rectangular frame-like form to cover the junction leads 9 of the lines of wire 6 and surround the mounting portion 10, as shown in FIG. 5(i). The covering layer 11 is formed by a known method using the photosensitive solder resist and the like.

Thereafter, exposed portions of the lines of wire 6 or the inner leads 7 and outer leads 8 are covered with a nickel plating layer and a gold plating layer, though not shown. The nickel plating layer and the gold plating layer are formed, for example, by the nickel plating and the gold plating, respectively.

Then, an opening 16 is formed in the metal supporting layer 2 at portions thereof corresponding to the conductor pattern forming portion 5, as shown in FIG. 5(j). The TAB tape carrier 1 is produced in the manner mentioned above.

The opening 16 is formed in the metal supporting layer 2 by opening the metal supporting layer 2 at the portions thereof corresponding to the conductor pattern forming portion 5 by a known process, such as, for example, drilling, punching, and wet etching (chemical etching). Take the etching for instance, after the whole area of the metal supporting layer 2, except the opening 16, is covered with the etching resist, the metal supporting layer 2 is etched using a known etching solution, such as solution of ferric chloride and, thereafter, the etching resist is -removed. Then, in the case where the TAB tape carriers 1 arranged in rows in the widthwise direction of the metal supporting layer 2 are produced, they are split into individual ones.

In the case where the TAB tape carriers 1 arranged in rows in the widthwise direction of the metal supporting layer 2 are produced simultaneously and then split into individual ones, a split portion of the metal supporting layer 2 between the TAB tape carriers 1 is also removed together with the opening 16.

In the TAB tape carrier 1 thus produced, since the metal supporting layer 2 has a specified degree of surface brilliancy of 500% or less, the pattern design of the conductor pattern 4 of fine pitch is examined with accuracy and reliability to determine whether it is good or bad, as mentioned above. Hence, the TAB tape carrier 1 on which highly reliable conductor patterns 4 are formed can be produced.

When an electronic component 21 is mounted on this TAB tape carrier 1, for example a positioning mark 25 and a positioning mark 26 are attached to a surface of the electronic component 21 and a surface of the insulating layer 3 (on which the conductor pattern 4 is formed), respectively, and also a position detecting apparatus 29 comprising a light source 27 and a photo detector 28 is set so that the light source 27 and the photo detector 28 are arranged in opposition with each other under the opening 16 of the insulating layer 3, as shown in FIG. 7. When light is emitted from the light source 27 toward the respective positioning marks 25, 26, the light is reflected by the respective marks 25, 26 and the reflected light is detected by the photo detector 28. This arrangement can allow the electronic component 21 and the conductor pattern 4 to be aligned with each other while recognizing these marks 25, 26.

Meanwhile, a trifling amount of metal supporting layer 2 as was removed in the process of forming the opening 16 shown in FIG. 5(j) is transferred to the rear side of the insulating layer 3 in the opening 16 and remains thereon. Due to this, when the degree of surface brilliancy of the metal supporting layer 2 is less than 150%, a haze value of the insulating layer 3 in the opening 16 increases, so that it becomes hard for the light emitted from the light source 27 and the light reflected from the marks 25, 26 to pass through that insulating layer 3, then hindering the alignment of the electronic component 21.

However, in this TAB tape carrier 1, since the metal supporting layer 2 has a specified degree of surface brilliancy of 150% or more, as mentioned above, excessive increase of the haze value of the insulating layer 3 exposed from the opening 16, which is due to the opening of the metal supporting layer 2, is prevented. This can allow the light for the alignment of the electronic component 21 to smoothly pass through the insulating layer 3, and as such can allow the electronic component 21 to be mounted with high accuracy.

From this viewpoint, the haze value of the insulating layer 3 in the opening 16 is set to be in the range of 20-50%, or preferably 30-45%. The haze value, which is determined by the following formula (1), can be measured in conformity with JIS K 7105 5.5, using a reflection and transmittance meter (HR-100 available from Murakami Color Research Laboratory).

Setting the haze value of the insulating layer 3 in the opening 16 at 20-50% can allow the light for the alignment of the electronic component 21 to pass through that insulating layer 3, and as such can allow the electronic component 21 to be mounted with high accuracy.

$$\text{Haze value (\%)} = Td/Tt \times 100 \qquad (1)$$

where Td represents total transmittance of light ray (%), and Tt represents diffuse transmittance (%).

Although the TAB tape carrier has been illustrated above for explaining the wired circuit board of the present invention, the wired circuit board of the present invention is widely applicable to other types of wired circuit boards, without being limited thereto.

## Examples

While in the following, the present invention will be described in further detail with reference to Examples and Comparative Examples, the present invention is not limited to any of the examples and comparative examples.

In the following examples, operations for producing four lines of TAB tape carriers of 48mm wide simultaneously were repeated two or more times using a stainless foil of 250mm wide.

## Example 1

A metal supporting layer of a stainless foil having a degree of surface brilliancy of 200% (SUS304 of 20 μm thick and 250mm wide) was prepared, first (Cf. FIG. 4(a)). Then, solution of polyamic acid resin was coated over the metal supporting layer and then was dried. Thereafter, it was cured by heating, to form an insulating layer of polyimide resin having thickness of 25 μm (Cf. FIG. 4(b)). Sequentially, a thin chromium film having thickness of 300Å and a thin copper film having thickness of 2,000Å were sequentially formed on the insulating layer by sputtering, to form a seed film (Cf. FIG. 4(c)).

Thereafter, a number of sprocket holes were bored by punching, to extend through the metal supporting layer, the insulating layer, and the seed film in the thickness direction thereof (Cf. FIG. 4(d)). Then, a plating resist having a predetermined pattern was formed on a surface of the seed film and another plating resist was formed on the entire surface of the metal supporting layer (Cf. FIG. 5(e)).

Then, the resulting one was dipped in electrolytic plating solution of copper sulfate and plated by electrolytic copper plating at 2.5A/dm$^2$ for about twenty minutes, to form conductor patterns having thickness of 10 μm on the seed film exposed from the plating resist (Cf. FIG. 5(f)).

Each of the conductor patterns was formed in the form of a wiring pattern comprising a number of lines of wire arranged at predetermined spaced locations, each line of wire comprising an inner lead, an outer lead, and a junction lead which were integrally formed to extend continuously. An inner lead pitch was 30 μm and an outer lead pitch was 100 μm.

Sequentially, the plating resists were removed by chemical etching (Cf. FIG. 5(g)) and thereafter the seed film exposed from the conductor pattern was also removed by the same chemical etching (Cf. FIG. 5(h)).

Thereafter, the resulting one was examined to see the presence of a short circuit between the lines of wire based on a pattern design of the conductor pattern by a light reflection method using an automatic optical inspection equipment, so as to determine and select the non-defective ones. Thereafter, the selected one was subjected to a continuity inspection for a confirmatory test, to confirm that no erroneous determination was presented by the automatic optical inspection equipment.

Thereafter, a photosensitive solder resist was formed to cover the junction leads of the lines of wire and surround the conductor pattern forming portion (Cf. FIG. 5(i)). Thereafter, the inner leads and outer leads were covered with a nickel plating layer and a gold plating layer formed by nickel plating and gold plating, respectively.

Then, after the entire surface of the metal supporting layer, except portions thereof corresponding to a conductor pattern forming portion and a slit forming portion, was covered with etching resist, the metal supporting layer was etched using solution of ferric chloride, to form an opening and a slit portion between the TAB tape carriers (Cf. FIG. 5(j)). The TAB tape carrier was produced in the manner outlined above. The haze value of the insulating layer of the TAB tape carrier thus produced was 40%.

Sequentially, an IC chip was mounted on the TAB tape carrier obtained using an IC mounting device (inner lead bonding), while being positioned by the light reflection method using a position detecting apparatus. In the mounting process, a mark on the IC chip and a mark on the conductor pattern could be well recognized to mount the IC chip at the correct position.

**Example 2**

Except that a stainless foil having the degree of surface brilliancy of 450% was used, the same operations as those of Example 1 were performed to produce the TAB tape carrier. It was confirmed by the subsequent continuity inspection that the examination result that no erroneous determination was presented as was obtained by the examination of the TAB tape carrier based on the pattern design of the conductor pattern by the light reflection test was correct.

The haze value of the insulating layer of the TAB tape carrier thus produced was 20%. When an IC chip was mounted on the TAB tape carrier obtained in the same manner as in Example 1, the IC chip was mounted at the correct position.

**Comparative Example 1**

Except that a stainless foil having the degree of surface brilliancy of 800% was used, the same operations as those of Example 1 were performed to produce the TAB tape carrier. It was confirmed by the subsequent continuity inspection that defective ones were mixed in those that were recognized to be non-defective by the examination of the TAB tape carrier based on the pattern design of the conductor pattern by the light reflection test.

The haze value of the insulating layer of the TAB tape carrier thus produced was 5%.

**Comparative Example 2**

Except that a stainless foil having the degree of surface brilliancy of 100% was used, the same operations as those of Example 1 were performed to produce the TAB tape carrier. It was confirmed by the subsequent continuity inspection that the examination result that no erroneous determination was presented as was obtained by the examination of the TAB tape carrier based on the pattern design of the conductor pattern by the light reflection test was correct.

The haze value of the insulating layer of the TAB tape carrier thus produced was 60%. When an IC chip was mounted on the TAB tape carrier obtained in the same manner as in Example 1, it was found that the mark on the IC chip and the mark on the conductor pattern could not be well recognized by the light reflection method, so that the IC chip mounted was out of position.

While the illustrative embodiments of the present invention are provided in the above description, such is for illustrative purpose only and it is not to be construed restrictively. Modification and variation of the present invention that will be obvious to those skilled in the art is to be covered by the following claims.

**Claims**

1.  A wired circuit board comprising a metal supporting layer having a degree of surface brilliancy of 150-500%, an insulating layer formed on the metal supporting layer, and a conductor pattern formed on the insulating layer.

2.  A wired circuit board comprising an insulating layer having a haze value of 20-50%, and a conductor pattern formed on the insulating layer.

FIG. 1

FIG. 2

FIG. 3

FIG. 4

( a )                                    ~2

( b )                                    ~3
                                         ~2

( c )                                    14
                                         ~3
                                         ~2

( d )    13                    13        14
                                         ~3
                                         ~2

# FIG. 5

(e)

(f)

(g)

(h)

(i)

(j)

1

FIG. 6

FIG. 7

FIG. 8

**European Patent Office**

## EUROPEAN SEARCH REPORT

Application Number

EP 05 01 0862

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 013, no. 434 (M-875), 28 September 1989 (1989-09-28) & JP 01 166956 A (SHIN KOBE ELECTRIC MACH CO LTD), 30 June 1989 (1989-06-30) * abstract * | 1 | H05K1/05 H05K1/02 H05K3/30 H01L23/498 |
| A | US 6 014 209 A (BISHOP) 11 January 2000 (2000-01-11) * abstract * | 1 | |
| A | US 5 965 036 A (MAKI ET AL) 12 October 1999 (1999-10-12) * column 6, line 40 - line 52 * | 1 | |
| A | US 4 661 417 A (SUZUKI ET AL) 28 April 1987 (1987-04-28) * claims; figure 9; example 5 * | 1 | |
| X | PATENT ABSTRACTS OF JAPAN vol. 2003, no. 12, 5 December 2003 (2003-12-05) & JP 2004 098659 A (UBE IND LTD), 2 April 2004 (2004-04-02) * abstract * | 2 | TECHNICAL FIELDS SEARCHED (Int.Cl.7) H05K |
| P,X | -& US 2004/110015 A1 (NARUI ET AL) 10 June 2004 (2004-06-10) * examples * | 2 | |
| X | US 4 806 432 A (EGUCHI ET AL) 21 February 1989 (1989-02-21) * the whole document * | 2 | |

-/--

The present search report has been drawn up for all claims

| Place of search | Date of completion of the search | Examiner |
|---|---|---|
| The Hague | 25 August 2005 | Mes, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 05 01 0862

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 013, no. 201 (E-757), 12 May 1989 (1989-05-12) & JP 01 022000 A (TOSHIBA CORP), 25 January 1989 (1989-01-25) * abstract * | 2 | |
| A | PATENT ABSTRACTS OF JAPAN vol. 2000, no. 06, 22 September 2000 (2000-09-22) & JP 2000 068326 A (SEIKO EPSON CORP), 3 March 2000 (2000-03-03) * abstract * | 2 | |
| D,A | PATENT ABSTRACTS OF JAPAN vol. 2000, no. 15, 6 April 2001 (2001-04-06) -& JP 2000 340617 A (HITACHI CABLE LTD), 8 December 2000 (2000-12-08) * abstract * | 1 | |

TECHNICAL FIELDS SEARCHED (Int.Cl.7)

The present search report has been drawn up for all claims

| Place of search | Date of completion of the search | Examiner |
|---|---|---|
| The Hague | 25 August 2005 | Mes, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 01 0862

This annex lists the patent family members relating to the patent documents cited in the above-mentioned European search report.
The members are as contained in the European Patent Office EDP file on
The European Patent Office is in no way liable for these particulars which are merely given for the purpose of information.

25-08-2005

| Patent document cited in search report | | Publication date | Patent family member(s) | | Publication date |
|---|---|---|---|---|---|
| JP 01166956 | A | 30-06-1989 | NONE | | |
| US 6014209 | A | 11-01-2000 | NONE | | |
| US 5965036 | A | 12-10-1999 | EP | 0855454 A1 | 29-07-1998 |
| | | | JP | 3458023 B2 | 20-10-2003 |
| | | | JP | 9041162 A | 10-02-1997 |
| | | | DE | 69715804 D1 | 31-10-2002 |
| | | | DE | 69715804 T2 | 28-05-2003 |
| US 4661417 | A | 28-04-1987 | JP | 1837058 C | 11-04-1994 |
| | | | JP | 4007899 B | 13-02-1992 |
| | | | JP | 61094756 A | 13-05-1986 |
| | | | JP | 60143689 A | 29-07-1985 |
| | | | JP | 1036997 B | 03-08-1989 |
| | | | JP | 1552413 C | 23-03-1990 |
| | | | JP | 60143693 A | 29-07-1985 |
| | | | DE | 3447669 A1 | 18-07-1985 |
| | | | KR | 9203400 B1 | 30-04-1992 |
| JP 2004098659 | A | 02-04-2004 | US | 2004110015 A1 | 10-06-2004 |
| US 2004110015 | A1 | 10-06-2004 | JP | 2004098659 A | 02-04-2004 |
| US 4806432 | A | 21-02-1989 | JP | 1871911 C | 26-09-1994 |
| | | | JP | 5082996 B | 24-11-1993 |
| | | | JP | 62122193 A | 03-06-1987 |
| | | | JP | 62122192 A | 03-06-1987 |
| | | | DE | 3677714 D1 | 04-04-1991 |
| | | | EP | 0223716 A2 | 27-05-1987 |
| JP 01022000 | A | 25-01-1989 | NONE | | |
| JP 2000068326 | A | 03-03-2000 | NONE | | |
| JP 2000340617 | A | 08-12-2000 | JP | 3555502 B2 | 18-08-2004 |

EPO FORM P0459

For more details about this annex : see Official Journal of the European Patent Office, No. 12/82